Europäisches Patentamt

European Patent Office

Office européen des brevets

(11) Publication number: **0 246 743**
**A2**

## (12) EUROPEAN PATENT APPLICATION

(21) Application number: **87302780.9**

(22) Date of filing: **31.03.87**

(51) Int. Cl.4: **B41N 1/24** , **G03F 7/12**

(30) Priority: **21.05.86 GB 8612407**

(43) Date of publication of application:
**25.11.87 Bulletin 87/48**

(84) Designated Contracting States:
**BE CH DE FR GB IT LI LU NL SE**

(71) Applicant: **AUTOTYPE INTERNATIONAL LIMITED**
**Grove Road**
**Wantage Oxon OX12 7BZ(GB)**

(72) Inventor: **Balfour, Ross Alexander**
**36 Mallard Way Grove**
**Wantage Oxon OX12 0QQ(GB)**
Inventor: **Griffiths, Peter Wynne**
**1 Grove Road**
**Wantage Oxon OX12 7BU(GB)**

(74) Representative: **Oliver, Roy Edward et al**
**POLLAK MERCER & TENCH High Holborn**
**House 52-54 High Holborn**
**London WC1V 6RY(GB)**

(54) **Blockout materials for printing screens.**

(57) Printing screen blockout material is made from a form of polyvinyl alcohol which contains carboxyl groups, which is made into a liquid coating composition also containing an inert filler and an acid catalyst. The composition has a pH below 4.0 and undergoes cross-linking in use, to give a blockout coating which resists solvent-based inks and can be washed out simply with aqueous periodate solution followed by water.

EP 0 246 743 A2

## BLOCKOUT MATERIALS FOR PRINTING SCREENS

In screen printing, the printed image is formed by forcing ink through a woven mesh, which carries a negative resist image. There are a number of ways of forming the negative resist image from a photosensitive emulsion.

In the so-called "direct" method, the wet photosensitive emulsion is coated directly on to the mesh, this coating is then dried and the prepared screen is then exposed to the photographic positive. As the whole of the mesh area is covered by the emulsion and, in use, this is hardened, by exposure to light, except in the image areas, there is no possibility of any seepage of ink through non-image areas.

The direct method has considerable technical limitations in its use. For example, there may be inconsistencies in the thickness of the stencil. When a thick stencil is required, it is very time-consuming to apply an emulsion coating repeatedly and then dry the coated mesh each time. If a thin stencil is used, poor print image quality can easily be caused by the pattern of the mesh at the edge of the print image. The principal advantage of the direct method is that the final stencil is very firmly bonded to the fibres of the mesh, resulting in long print-runs, with no possibility of adhesion failure between the mesh and the stencil.

To maintain the advantages and to avoid the disadvantages of the method, so-called "capillary films" have been developed. In these, an emulsion of the "direct" type is coated on to a carrier or backing foil and dried, so as to achieve a coating of carefully controlled thickness. The unexposed emulsion coating is placed in contact with a water-moistened screen. The water softens the surface of the emulsion and this allows the mesh to sink into it. The screen is dried and the backing foil is then removed and replaced by the photographic positive, before exposure and processing are carried out in the usual way. The stencil so produced has the durability of those produced by the direct method, together with a controlled thickness, and the advantage that a flat surface is presented to the printing stock. The quality of the print image is much improved and the durability is maintained. Capillary films are much better than screens produced by the direct method, but their cost is higher. Therefore, it is generally more expensive to prepare a printing-screen via the capillary film route. However, this additional cost can be minimised, by employng only sufficient film to cover the image area adequately, thus leaving an open area of mesh around the edge of the screen.

Also, it is virtually impossible and is certainly not convenient to cut the capillary film so that it exactly fills the mesh area of the screen. For these reasons, it is therefore common practice to use capillary type screens which have open areas in them. Before printing, these open areas have to be masked out by a so-called "blockout" filler. This is applied as a liquid and, when dry, it forms a coating which adequately resists the penetration of ink during the printing process. In practice, it is necessary for both the stencil and the blockout layer to be easily removable, at the end of the printing process, so that the screen mesh can be reclaimed and reused.

The capillary film is usually based on polyvinyl alcohol, which, even after the photohardening step used to make the photostencil and subsequent exposure to printing inks, can be removed by the application of a solution of a periodate salt, as disclosed in GB-PS 1,375,402. The blockout filler may also be based on polyvinyl alcohol or it may be based on cellulose derivatives, such as ethyl cellulose, which although resistant to solvent-based printing inks may be removed by washing with water during the subsequent cleaning operation.

Recently, a considerable interest has developed in the use of screenprinting inks which may be thinned by water. These generally contain, as well as pigments and suitable binders, surfactants and some quantity of water-miscible solvent. They have the advantage that the working viscosity may be controlled by the addition of water, resulting in reduced cost and less toxic hazard, and the additional benefit that ink may be removed from screens at the end of a print run simply by washing in water. Whilst it is possible to formulate emulsions for capillary films which are adequate in their resistance to such inks after photohardening, the conventional blockout fillers will not resist such inks during the printing process. There is therefore a considerable need for an improved form of blockout filler which has the appropriate properties to be fully usable with all kinds of screenprinting systems and inks and, particularly, those which are water-based.

The present invention is based upon the surprising discovery that a coating composition can be made, which is suitable for use as a universal blockout filler.

According to a first aspect of the present invention, a blockout material for printing screens is provided, which comprises a liquid composition based upon polyvinyl alcohol and an inert filler, characterised in that the polyvinyl alcohol comprises a hydrolysed copolymer of vinyl acetate and a carboxyl-containing monomer, the copolymer being hydrolysed sufficiently to be water-soluble, and that the composition has a pH value below 4.0.

It is postulated that the method by which the blockout material works is that, after application to the screen and during the drying cycle, the acid, which acts as a catalyst for a hardening reaction, causes esterification of the carboxyl groups by the hydroxyl groups of the polyvinyl alcohol, so giving cross-linking and rendering the dried material insoluble in conventional ink solvents and also in water and water/solvent mixtures.

After printing and during the subsequent cleaning operation, the cross-linked polyvinyl alcohol material, as well as the hardened stencil, may be removed by the application of periodate solution, followed by washing with water. This obviates the requirement for separate treatment for the removal of the dried blockout material and also ensures that the screen mesh is easily reclaimed for subsequent re-use.

The polyvinyl alcohol may be selected from any form of hydrolysed, i.e. saponified, copolymer of vinyl acetate with any desired proportion of a carboxyl-containing monomer, provided the copolymer is sufficiently hydrolysed to give water-solubility to the polyvinyl alcohol. The carboxyl-containing monomer can be maleic anhydride, acrylic acid or methacrylic acid, for instance.

The acid incorporated in the composition may be any mineral or organic acid and is present in a sufficient quantity to reduce the pH of the solution below 4.0. Preferably, the pH of the composition is in the range from 1.5 to 3.0.

The inert filler may be an inorganic filler such as silica, but it is preferred to use resin dispersions in water, such as polyvinyl acetate, ethylene-vinyl acetate copolymers, styrene-butadiene copolymers, polychloroprene or polyvinylidene-chloride and their copolymers and mixtures thereof.

A proportion of a dispersed pigment is also preferably included in the blockout material.

In order that the invention may be better understood and more fully appreciated, reference is made to the following non-limitative Examples, wherein Examples 1 and 3 relate to the invention and Example 2 is given for comparison purposes. Proprietary products used in these Examples are described in detail at the end.

EXAMPLE 1

An emulsion was prepared from the following components:
Polyvinyl alcohol containing free carboxyl groups "Poval KL 318" 9.425 kg

Water 47.500 kg
Polyvinylacetate homopolymer "Vinnapas M50" 37.648 kg
10% hydrochloric acid 5.492 kg

The emulsion was coated on to both sides of a 90 threads/cm polyester screen printing mesh and dried in a stream of warm air for 10 minutes. When dry, the coating would not redissolve in hot water and would not swell or redissolve when left in contact with a 50:50 butanol:water blend. On application of an aqueous 1% sodium periodate solution, the coating quickly dissolved and was easily removed by subsequent spraying with water.

EXAMPLE 2

By way of comparison, the following emulsion was prepared:
<Polyvinyl alcohol containing no carboxyl groups "Mowiol 26/88" 9.425 kg
Water 47.500 kg
Polyvinylacetate homopolymer "Vinnapas M50" 37.648 kg
10% hydrochloric acid 5.492 kg

It will be seen that this emulsion is formed from exactly the same starting materials as that described in Example 1, except that the hydrolysed polyvinyl alcohol contains no carboxyl groups. Moreover, in this Example, the emulsion was coated and dried exactly as for Example 1. When dry, the coating was easily redissolved in water and was readily swollen when left in contact with a 50:50 butanol:water blend. This very significant difference in behaviour clearly is due to the presence of the carboxyl groups in the polyvinyl alcohol used in Example 1.

The following Example shows that other resin dispersions to that illustrated in Example 1 also give wholly effective blockout compositions.

Example 3

An emulsion was prepared from the following components:
Polyvinyl alcohol containing free carboxyl groups "Poval KL 318" 9.425 kg
Water 47.500 kg
Polyvinylidene chloride "Ixan WA50" 37.648 kg
10% hydrochloric acid 5.492 kg

The emulsion was coated and dried, as before, on to a 90 threads per cm polyester screen printing mesh which was partially covered by a stencil. In addition to excellent water and water-butanol resistance, the dried coating exhibited excellent adhesion to both the fibres of the mesh and the screen-printing stencil where it overlapped. The mesh could easily be reclaimed by the application of a solution of sodium periodate.

In the foregoing Examples:

"Poval" is a Regd. Trademark of Kuraray and "Poval KL 318" is an 88% hydrolysed polyvinyl alcohol containing free carboxyl groups;

"Mowiol" is a Regd. Trademark of Harlow Chemicals and "Mowiol 26/88" is an 88% hydrolysed grade of polyvinyl alcohol containing no carboxyl groups;

"Vinnapas" is a Regd. Trademark of Wacker Chemicals and "Vinnapas M50" is an aqueous dispersion of polyvinyl acetate homopolymer;

"Ixan" is a Regd. Trademark of Laporte Industries and "Ixan WA50" is an aqueous dispersion of polyvinylidene chloride.

## Claims

1. A blockout material for printing screens, which comprises a liquid coating composition based upon polyvinyl alcohol and at least one inert filler,
characterised in that
the polyvinyl alcohol comprises a hydrolysed copolymer of vinyl acetate and a carboxyl-containing monomer, the copolymer being hydrolysed sufficiently to be water-soluble, and that the composition has a pH value below 4.0.

2. A blockout material according to claim 1, wherein the carboxyl-containing monomer is selected from maleic anhydride, acrylic acid, methacrylic acid and mixtures thereof.

3. A blockout material according to claim 1 or 2, wherein the composition includes a sufficient quantity of at least one mineral or organic acid to adjust its pH to the desired value.

4. A blockout material according to any preceding claim, wherein the pH of the composition is in the range from 1.5 to 3.0.

5. A blockout material according to any preceding claim, wherein an inorganic filler is present.

6. A blockout material according to claim 5, wherein silica is included as a filler.

7. A blockout material according to any preceding claim, wherein at least one resin dispersion selected from polyvinyl acetate, ethylene-vinyl acetate copolymers, styrene-butadiene copolymers, polychloroprene, polyvinylidene-chloride or their copolymers or mixtures thereof is included, as the inert filler.

8. A blockout material according to any preceding claim, wherein a dispersed pigment is present.

9. A method of manufacture of a printing screen, in which a capillary film is used to make a screen having an open area which, before printing is carried out, is masked by application of a blockout material comprising a liquid composition which is then dried,
characterised in that
the blockout material used has a composition as defined in any preceding claim.